# EUROPEAN PATENT APPLICATION

(11) **EP 4 704 336 A1**
(43) Date of publication of application: **04.03.2026**
(21) Application number: 25177310.7
(22) Date of filing: 19.05.2025
(51) Int. Cl.: H03F 1/08, H03F 3/45

(54) **TRANSCONDUCTANCE-TRANSIMPEDANCE AMPLIFIER WITH ONE OR MORE COMMON-MODE FEEDBACK LOOPS**

(30) Priority: 26.08.2024 US 202418814599
(71) Applicant: Airoha Technology Corp., 300 Hsinchu City (TW)
(72) Inventor: WU, Chung-Ru, 333 Taoyuan City (TW); HSIEH, Yi-Keng, 302 Zhubei City, Hsinchu County (TW); WU, Min-Hua, 302 Zhubei City, Hsinchu County (TW)
(74) Representative: Hoefer & Partner Patentanwälte mbB

(57) **Abstract**

A transconductance-transimpedance, TAS-TIA, amplifier (100) includes a TAS amplifier (102), a TIA amplifier, (104) and a first common-mode feedback, CMFB, circuit (106). The TIA amplifier (104) includes a first transistor (M1N) and a second transistor (M2N). The first CMFB circuit (106) has a first operational amplifier (110), a first capacitor (112), and a first resistor (114). The first operational amplifier (110) has a first input node (+) for receiving a TIA output common-mode voltage (V_{CMO}), a second input node (-), and a first output node coupled to control terminals of the first and second transistors (M1N, M2N). The first capacitor (112) is coupled between the first output node and the second input node (-) of the first operational amplifier (110). The first resistor (114) is coupled between the second input node (-) of the first operational amplifier (110) and a reference common-mode voltage (V_{REF}).

## Description

### BACKGROUND OF THE INVENTION

### 1. FIELD OF THE INVENTION

The present invention relates to an amplifier design, and more particularly, to a transconductance-transimpedance amplifier with one or more common-mode feedback loops.

### 2. DESCRIPTION OF THE PRIOR ART

Transconductance-transimpedance (TAS-TIA) amplifier is a widely used architecture for low-voltage, high-speed receivers. A transconductance stage (which can be also denoted as a transadmittance stage) transfers a differential voltage input to a differential current output, where a differential pair is a general block of the transconductance amplifier because of transmitters' high input and output impedance attribute as well as they provide transconductance gain inherently. A transimpedance stage then turns this differential current output of the transconductance stage into a differential voltage output with signal amplification, where a high-gain amplifier with a feedback network that provides low input and output impedances has a transimpedance topology. For example, a complementary metal-oxide-semiconductor (CMOS) inverter that is biased by an independent bias current and accompanied with a feedback network is a common architecture of the transimpedance stage because of its good power efficiency.

The TAS-TIA amplifier output common-mode voltage is defined by the TIA bias current, transistor sizes, and transistor types. In some applications, a specific TAS-TIA amplifier output common-mode voltage is requested by a subsequent circuit. Thus, there is a need for an innovative common-mode feedback circuit design for adjusting the TAS-TIA amplifier output common-mode voltage to meet requirements of the subsequent circuit.

### SUMMARY OF THE INVENTION

One of the objectives of the claimed invention is to provide a transconductance-transimpedance amplifier with one or more common-mode feedback loops. Transconductance-transimpedance amplifiers according to the present invention are defined in the independent claims. The dependent claims define preferred embodiments thereof.

According to a first aspect of the present invention, an exemplary transconductance-transimpedance (TAS-TIA) amplifier is disclosed. The exemplary TAS-TIA amplifier includes a TAS amplifier, a TIA amplifier, and a first common-mode feedback (CMFB) circuit. The TAS amplifier is arranged to receive a differential voltage input at a TAS differential input port, and is further arranged to generate a differential current output at a TAS differential output port. The TIA amplifier has a TIA differential input port coupled to the TAS differential output port, and is arranged to generate a differential voltage output at a TIA differential output port, wherein the TIA differential output port comprises a first TIA output node and a second TIA output node. The TIA amplifier comprises a first transistor and a second transistor. The first transistor comprises: a first control terminal; a first connection terminal, coupled to the first TIA output node; and a second connection terminal, coupled to a reference voltage. The second transistor comprises: a second control terminal; a third connection terminal, coupled to the second TIA output node; and a fourth connection terminal, coupled to the reference voltage. The first common-mode feedback (CMFB) circuit comprises a first operational amplifier, a first capacitor, and a first resistor. The first operational amplifier comprises: a first input node, arranged to receive a TIA output common-mode voltage of the TIA amplifier; a second input node; and a first output node, coupled to the first control terminal of the first transistor and the second control terminal of the second transistor. The first capacitor is coupled between the first output node and the second input node of the first operational amplifier. The first resistor has a first end coupled to the second input node of the first operational amplifier, and a second end arranged to receive a reference common-mode voltage.

According to a second aspect of the present invention, an exemplary transconductance-transimpedance (TAS-TIA) amplifier is disclosed. The exemplary TAS-TIA amplifier includes a TAS amplifier, a TIA amplifier, and a common-mode feedback (CMFB) circuit. The TAS amplifier is arranged to receive a differential voltage input at a TAS differential input port, and generate a differential current output at a TAS differential output port. The TAS amplifier includes a first controllable current source and a second controllable current source. The TIA amplifier has a TIA differential input port coupled to the TAS differential output port, and is arranged to generate a differential voltage output at a TIA differential output port. The CMFB circuit is arranged to control the first controllable current source and the second controllable current source.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG. 1 is a diagram illustrating one transconductance-transimpedance amplifier with a proposed common-mode feedback design according to an embodiment of the present invention.
FIG. 2 is a diagram illustrating another transconductance-transimpedance amplifier with the proposed common-mode feedback design according to an embodiment of the present invention.

### DETAILED DESCRIPTION

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

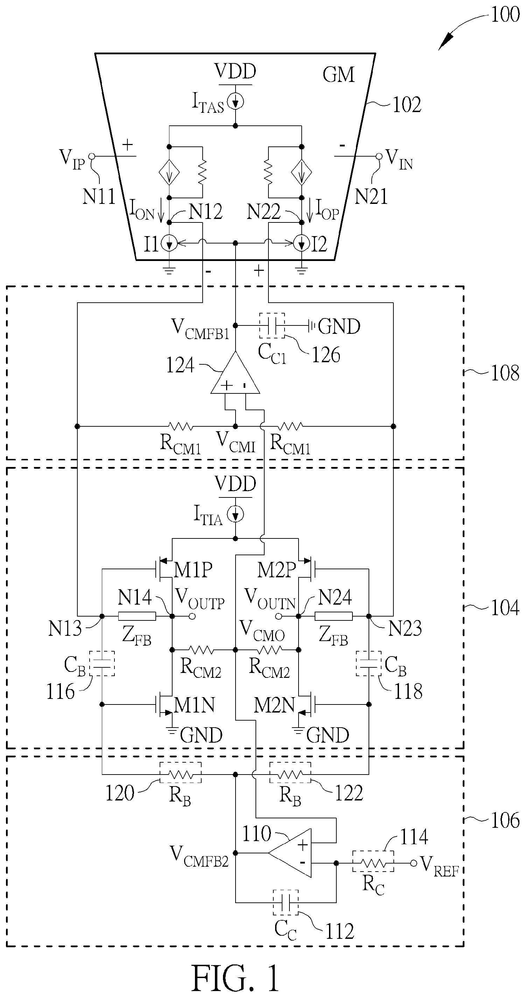

FIG. 1 is a diagram illustrating one transconductance-transimpedance (TAS-TIA) amplifier with a proposed common-mode feedback (CMFB) design according to an embodiment of the present invention. The TAS-TIA amplifier 100 includes a TAS amplifier (i.e., a transconductance amplifier that is also denoted as a transadmittance amplifier) 102, a TIA amplifier (i.e., a transimpedance amplifier) 104, and a plurality of CMFB circuits 106, 108. The TAS amplifier 102 is biased by an independent current source (labeled by "I_{TAS}"), and also includes a plurality of controllable current sources (labeled by "I1" and "12") such as voltage controlled current sources (VCCSs). The TAS amplifier 102 with a transconductance gain GM is arranged to receive a differential voltage input (V_{IP}, V_{IN}) at a TAS differential input port (which includes TAS input nodes N11 and N21), and generate a differential current output (I_{ON}, I_{OP}) at a TAS differential output port (which includes TAS output nodes N12 and N22) . Preferably, the TAS amplifier 102 may be implemented using any typical TAS amplifier structure. Further description of the principles of the TAS amplifier 102 is omitted here for brevity.

The TIA amplifier 104 has a TIA differential input port (which includes TIA input nodes N13 and N23) and a TIA differential output port (which includes TIA output nodes N14 and N24). The TIA differential input port (N13, N23) of the TIA amplifier 104 is coupled to the TAS differential output port (N12, N22) of the TAS amplifier 102. The TIA amplifier 104 is arranged to generate a differential voltage output (V_{OUTP}, V_{OUTN}) at the TIA differential output port (N14, N24). The TIA amplifier 104 may be implemented using any typical TIA amplifier structure. For example, the TIA amplifier 104 includes a CMOS inverter that is biased by an independent bias current (labeled by "I_{TIA}") and accompanied with a feedback network including feedback resistors (labeled by "Z_{FB}"), where the independent bias current (labeled by "I_{TIA}") defines TIA bandwidth and gain, and the CMOS inverter includes P-channel metal-oxide-semiconductor (PMOS) transistors M1P, M2P and N-channel metal-oxide-semiconductor (MMOS) transistors M1N, M2N. Since a person skilled in the art can readily understand the principles of the TIA amplifier 104, further description is omitted here for brevity.

The present invention is focused on the CMFB design employed by a TAS-TIA amplifier. As shown in FIG. 1, the CMFB circuit 106 includes an operational amplifier 110, a capacitor (labeled by "C_{C}") 112, a resistor (labeled by "R_{C}") 114, and other resistors (labeled by "R_{B}") 120, 122. The operational amplifier 110 has a non-inverting input node (labeled by "+") arranged to receive a TIA output common-mode voltage V_{CMO} of the TIA amplifier 104, and further has an inverting input node (labeled by "-") coupled to a reference output common-mode voltage V_{REF} (which may be a specific common-mode voltage requested by a subsequent circuit) via the resistor 114 and also coupled to an output node via the capacitor 112 (which acts as a Miller capacitor) . The TIA output common-mode voltage V_{CMO} is generated from a voltage divider that is coupled between the TIA output nodes N14 and N24 and includes two resistors (labeled by "R_{CM2}") with the same resistance value.

A control voltage V_{CMFB2} generated in response to the difference between the TIA output common-mode voltage V_{CMO} and the reference output common-mode voltage V_{REF} is supplied to a control terminal (gate terminal) of the NMOS transistor M1N via the resistor 120, and is also supplied to a control terminal (gate terminal) of the NMOS transistor M2N via the resistor 122. Regarding the NMOS transistor M1N, it has one connection terminal (drain terminal) coupled to the TIA output node N14, and another connection node (source terminal) coupled to a reference voltage such as a ground voltage GND. Regarding the NMOS transistor M2N, it has one connection terminal (drain terminal) coupled to the TIA output node N24, and another connection node (source terminal) coupled to the reference voltage such as the ground voltage GND. Hence, the TIA output common-mode voltage V_{CMO} can be increased/decreased by adjusting the control voltage V_{CMFB2} that is applied to the control terminals (gate terminals) of the NMOS transistors M1N and M2N.

In this embodiment, the TIA amplifier 104 has one capacitor (labeled by "C_{B}") 116 that provides AC coupling between the TIA input node N13 and the control terminal (gate terminal) of the NMOS transistor M1N, and has another capacitor (labeled by "C_{B}") 118 that provides AC coupling between the TIA input node N23 and the control terminal (gate terminal) of the NMOS transistor M2N. In this way, the NMOS transistors M1N and M2N can be reused for signal amplification. The use of the resistor 120/122 and the capacitor 116/118 may ensure that the proposed CMFB circuit 106 can operate as intended. However, the resistor 120/122 and the capacitor 116/118 may create an additional low-frequency pole in the CMFB loop. To achieve amplifier stability, a criterion of **A · R_{C} · C_{C}** » R_{C} **·** C_{B} should be met, where A is the open-loop gain of the operational amplifier 110. Since the capacitor 112 is coupled between the output terminal and the inverting terminal of the operational amplifier 110 to act as a Miller capacitor for frequency compensation and the open-loop gain A of the operational amplifier 110 is generally large (e.g., A = 100~200), the criterion of **A · R_{C} · C_{C} » R_{B} · C_{B}** can be met without using a large-sized capacitor to implement the capacitor 112. In this way, the chip area and the production cost of the CMFB circuit 106 can be reduced.

As shown in FIG. 1, the operational amplifier 110 outputs the control voltage V_{CMFB2} to the control terminals (gate terminals) of the NMOS transistors M1N and M2N for adjusting the TIA output common-mode voltage V_{CMO}. Compared to one conventional CMFB design that outputs a control voltage to additional components (e.g., current sources) for adjusting the TIA output common-mode voltage, the proposed CMFB circuit 106 does not suffer drawbacks (e.g., noise, mismatch, and parasitic capacitance) induced by the conventional CMFB design. Compared to another conventional CMFB design that outputs a control voltage to directly adjust the TIA bias current, the proposed CMFB circuit 106 does not suffer drawbacks (e.g., TIA performance degradation, including bandwidth degradation, gain degradation, and linearity degradation) induced by the conventional CMFB design. To put it simply, the TAS-TIA amplifier 100 with the proposed CMFB design can meet the requirements of high speed, low noise, and high linearity.

The CMFB circuit 106 is used to adaptively adjust the TIA output common-mode voltage V_{CMO}. In addition to the CMFB circuit 106, the TAS-TIA amplifier 100 may further include another CMFB circuit 108 for adaptively adjusting the TIA input common-mode voltage V_{CMI}. As shown in FIG. 1, the CMFB circuit 108 includes an operational amplifier 124 that is arranged to control the controllable current sources (labeled by "I1" and "12") of the TAS amplifier 102. For example, each of the controllable current sources (labeled by "I1" and "12") may be a VCCS implemented using an NMOS transistor with a control terminal (gate terminal) coupled to an output node of the operational amplifier 124. The operational amplifier 124 has a non-inverting input node (labeled by "+") arranged to receive the TIA input common-mode voltage V_{CMI} of the TIA amplifier 104, and further has an inverting input node (labeled by "-") arranged to receive the TIA output common-mode voltage V_{CMO} of the TIA amplifier 104. The TIA input common-mode voltage V_{CMI} is generated from a voltage divider that is coupled between the TIA input nodes N13 and N23 and includes two resistors (labeled by "R_{CM1}") with the same resistance value. A control voltage V_{CMFB1} generated from the operational amplifier 124 is supplied to control terminals (gate terminals) of NMOS transistors that act as the controllable current sources (labeled by "I1" and "12") of the TAS amplifier 102. In addition, a capacitor (labeled by "C_{C1}") 126 acts as a frequency compensation capacitor, and is coupled between the output node of the operational amplifier 124 and a reference voltage such as the ground voltage GND.

The CMFB circuit 108 is used to enforce zero net current flowing through the TIA feedback network (which includes feedback resistors labeled by "Z_{FB}") by adjusting the controllable current sources (labeled by "I1" and "I2"). Ideally, the bias current I_{TAS} should be equal to I1+I2. However, due to certain factors such as device mismatches, non-zero net current resulting from difference between I_{TAS} and I1+I2 flows through the TIA feedback network (which includes feedback resistors labeled by "Z_{FB}") and affects TIA DC bias current which dominates TIA frequency response and linearity as well. To address this issue, the present invention proposes using the CMFB circuit 108 to monitor the difference between the TIA output common-mode voltage V_{CMO} and the TIA input common-mode voltage V_{CMI}. When the TIA output common-mode voltage V_{CMO} is not equal to the TIA input common-mode voltage V_{CMI}, it implies that there is non-zero net current (which results from difference between I_{TAS} and I1+I2) flowing through the TIA feedback network. Hence, the CMFB circuit 108 operates to reduce/cancel the non-zero net current by adaptively adjusting the controllable current sources (labeled by "I1" and "12") until the TIA input common-mode voltage V_{CMI} is equal to the TIA output common-mode voltage V_{CMO}. When the TIA input common-mode voltage V_{CMI} is enforced to be equal to the TIA output common-mode voltage V_{CMO}, it means that the TAS output voltage is kept the same as the TIA output voltage, which helps the TAS amplifier 102 to operate in a correct operation region for providing effective transconductance gain and linearity.

In the embodiment shown in FIG. 1, the CMFB circuits 106 and 108 are both employed by the TAS-TIA amplifier 100. However, this is for illustrative purposes only, and is not meant to be a limitation of the present invention. For example, one of the CMFB circuits 106 and 108 may be omitted, depending on actual design considerations. In one alternative design, the TAS-TIA amplifier 100 may be modified to employ the CMFB circuit 106 and omit the CMFB circuit 108. In another alternative design, the TAS-TIA amplifier 100 may be modified to employ the CMFB circuit 108 and omit the CMFB circuit 106.

The present invention is focused on the CMFB design employed by a TAS-TIA amplifier, and may not have limitations on the TAS amplifier design and/or the TIA amplifier design. For example, the CMFB circuit 106 may be applied to a TIA amplifier with an amplifier structure different from that shown in FIG. 1. For another example, the CMFB circuit 108 may be applied to a TAS amplifier with an amplifier structure different from that shown in FIG. 1.

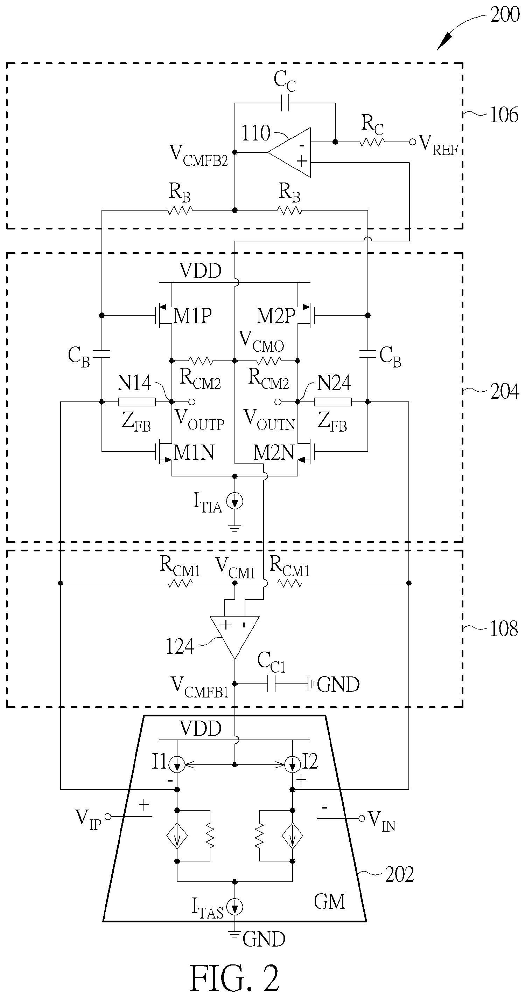

FIG. 2 is a diagram illustrating another TAS-TIA amplifier with a proposed CMFB design according to an embodiment of the present invention. The TAS-TIA amplifier 200 includes a TAS amplifier (i.e., a transconductance amplifier that is also denoted as a transadmittance amplifier) 202, a TIA amplifier (i.e., a transimpedance amplifier) 204, and the aforementioned CMFB circuits 106 and 108. In this embodiment, a CMOS inverter of the TIA amplifier 204 includes PMOS transistors M1P and M2P, and a TIA differential output port includes TIA output nodes N14 and N24. The PMOS transistor M1P has one connection terminal (drain terminal) coupled to the TIA output node N14, and has another connection terminal (source terminal) coupled to a reference voltage such as a supply voltage VDD. The PMOS transistor M2P has one connection terminal (drain terminal) coupled to the TIA output node N24, and has another connection terminal (source terminal) coupled to the reference voltage such as the supply voltage VDD. The control voltage V_{CMFB2} generated from the operation amplifier 110 is supplied to control terminals (gate terminals) of PMOS transistors M1P and M2P. The CMFB circuit 108 includes the operational amplifier 124 that is arranged to control the controllable current sources (labeled by "I1" and "12") of the TAS amplifier 202. For example, each of the controllable current sources (labeled by "I1" and "12") may be a VCCS implemented using a PMOS transistor with a control terminal (gate terminal) coupled to an output node of the operational amplifier 124. As a person skilled in the art can readily understand details of the CMFB circuits 106 and 108 after reading above paragraphs directed to the embodiment shown in FIG. 1, further description is omitted here for brevity.

It should be noted that any TAS-TIA amplifier using one or both of the CMFB circuits 106 and 108 falls within the scope of the present invention. The present invention has no limitations on the TAS amplifier design and/or TIA amplifier design. Preferably, at least one of the TAS amplifier 102/202 and the TIA amplifier 104/204 may be modified to employ an amplifier structure different from a typical amplifier structure. Consider a case where the TAS amplifier 102/202 is implemented using a TAS amplifier structure different from a typical TAS amplifier structure. Each of the controllable current sources (labeled by "I1" and "12") in the TAS amplifier 102/202 may be a VCCS implemented using a MOS transistor, and the TAS amplifier 102/202 may have the differential voltage input (V_{IP}, V_{IN}) AC-coupled to the control terminals (gate terminals) of the MOS transistors that act as the controllable current sources (labeled by "I1" and "I2"), such that the MOS transistors can be reused for signal amplification. However, this is for illustrative purposes only, and is not meant to be a limitation of the present invention.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A transconductance-transimpedance, in the following also referred to as TAS-TIA, amplifier (100; 200) comprising:
a TAS amplifier (102; 202), arranged to receive a differential voltage input (V_{IP}, V_{IN}) at a TAS differential input port (N11, N21), and generate a differential current output (I_{ON}, I_{OP}) at a TAS differential output port (N12, N22);
a TIA amplifier (104; 204), having a TIA differential input port (N13, N23) coupled to the TAS differential output port (N12, N22), and arranged to generate a differential voltage output (V_{OUTP}, V_{OUTN}) at a TIA differential output port (N14, N24), the TIA differential output port (N14, N24) comprises a first TIA output node (N14) and a second TIA output node (N24), and the TIA amplifier (104; 204) comprises:
a first transistor (M1N; M1P), comprising:
a first control terminal;
a first connection terminal, coupled to the first TIA output node (N14); and
a second connection terminal, coupled to a reference voltage (VDD);
a second transistor (M2N; M2P), comprising:
a second control terminal;
a third connection terminal, coupled to the second TIA output node (N24); and
a fourth connection terminal, coupled to the reference voltage (VDD); and
a first common-mode feedback, in the following also referred to as CMFB, circuit (106), comprising:
a first operational amplifier (110), comprising:
a first input node (+), arranged to receive a TIA output common-mode voltage (V_{CMO}) of the TIA amplifier (104; 204);
a second input node (-); and
a first output node, coupled to the first control terminal of the first transistor (M1N; M1P) and the second control terminal of the second transistor (M2N; M2P);
a first capacitor (112), coupled between the first output node and the second input node (-) of the first operational amplifier (110); and
a first resistor (114), having a first end coupled to the second input node (-) of the first operational amplifier (110), and a second end arranged to receive a reference common-mode voltage ₍V_{REF}).

2. The TAS-TIA amplifier (100; 200) of claim 1, wherein the TIA differential input port (N13, N23) comprises a first TIA input node and (N13) a second TIA input node (N23); the TIA amplifier (104; 204) further comprises:
a second capacitor (116), coupled between the first TIA input node (N13) and the first control terminal of the first transistor (M1N; M1P); and
a third capacitor (118), coupled between the second TIA input node (N23) and the second control terminal of the second transistor (M2N; M2P); and
the first CMFB circuit (106) further comprises:
a second resistor (120), coupled between the first output node of the first operational amplifier (110) and the first control terminal of the first transistor (M1N; M1P); and
a third resistor (122), coupled between the first output node of the first operational amplifier (110) and the second control terminal of the second transistor (M2N; M2P).

3. The TAS-TIA amplifier (100; 200) of claim 1 or 2, wherein the TAS amplifier (102; 202) comprises a first controllable current source (I1) and a second controllable current source (I2); and the TAS-TIA amplifier further comprises:
a second CMFB circuit (108), arranged to control the first controllable current source (I1) and the second controllable current source (I2).

4. The TAS-TIA amplifier (100; 200) of claim 3, wherein the second CMFB circuit (108) comprises a second operational amplifier (124), and the second operational amplifier (124) comprises:
a third input node (+), arranged to receive a TIA input common-mode voltage (V_{CMI}) of the TIA amplifier (104; 204);
a fourth input node (-), arranged to receive the TIA output common-mode voltage (V_{CMO}) of the TIA amplifier (104; 204);and
a second output node, coupled to the first controllable current source (I1) and the second controllable current source (I2) of the TAS amplifier (102; 202).

5. The TAS-TIA amplifier (100; 200) of claim 4, wherein the second CMFB circuit (108) further comprises:
a second capacitor (126), coupled between the second output node of the second operational amplifier (124) and a reference voltage (GND).

6. The TAS-TIA amplifier (100) of any one of claims 1 to 5, wherein each of the first transistor (M1N, M2N) and the second transistor is an N-channel metal-oxide-semiconductor, in the following also referred to as NMOS, transistor.

7. The TAS-TIA amplifier (200) of any one of claims 1 to 5, wherein each of the first transistor (M1P, M2P) and the second transistor is a P-channel metal-oxide-semiconductor, in the following also referred to as PMOS, transistor.

8. A transconductance-transimpedance, in the following also referred to as TAS-TIA, amplifier (100; 200) comprising:
a TAS amplifier (102; 202), arranged to receive a differential voltage input (V_{IP}, V_{IN}) at a TAS differential input port (N11, N21), and generate a differential current output (I_{ON}, I_{OP}) at a TAS differential output port (N12, N22), wherein the TAS amplifier (102; 202) comprises:
a first controllable current source (I1); and
a second controllable current source (I2);
a TIA amplifier (104; 204), having a TIA differential input port (N13, N23) coupled to the TAS differential output port (N12, N22), and arranged to generate a differential voltage output (V_{OUTP}, V_{OUTN}) at a TIA differential output port (N14, N24); and
a common-mode feedback, in the following also referred to as CMFB, circuit (108), arranged to control the first controllable current source (I1) and the second controllable current source (I2).

9. The TAS-TIA amplifier (100; 200) of claim 8, wherein the CMFB circuit (108) comprises an operational amplifier (124), and the operational amplifier (123) comprises:
a first input node (+), arranged to receive a TIA input common-mode voltage (V_{CMI}) of the TIA amplifier (104; 204);
a second input node (-), arranged to receive a TIA output common-mode voltage (V_{CMO}) of the TIA amplifier (104; 204); and
an output node, coupled to the first controllable current source (I1) and the second controllable current source (I2) of the TAS amplifier (102; 202).

10. The TAS-TIA amplifier (100; 200) of claim 9, wherein the CMFB circuit (108) further comprises:
a capacitor (126), coupled between the output node of the operational amplifier (124) and a reference voltage (GND).
